# EUROPEAN PATENT APPLICATION

(11) **EP 4 834 968 A1**
(43) Date of publication of application: **04.11.2026**
(21) Application number: 24912543.6
(22) Date of filing: 17.12.2024
(51) Int. Cl.: C08G 59/24, C08G 59/32, C08K 3/013, C08L 63/00, H01L 23/29, H01L 23/31

(54) **CURABLE RESIN COMPOSITION AND ELECTRONIC COMPONENT DEVICE**

(30) Priority: 26.12.2023 JP 2023219887
(71) Applicant: Resonac Corporation, Tokyo 105-7325 (JP)
(72) Inventor: NISHIYAMA, Tomoo, Tokyo 105-7325 (JP); TAIRA, Ayako, Tokyo 105-7325 (JP); YAMAMOTO, Takaya, Tokyo 105-7325 (JP)
(74) Representative: Hoffmann Eitle
(86) International application number: PCT/JP2024/044672
(87) International publication number: WO 2025/142654

(57) **Abstract**

This curable resin composition contains an epoxy resin. A cured product of the curable resin composition exhibits an adhesive strength of 0.40 MPa or more with respect to AgCu at 260°C after being heated and humidified for 168 hours at 85°C and 85% RH.

## Description

### Technical Field

The disclosure relates to a curable resin composition and an electronic component device.

### Related Art

In recent years, high-density mounting of semiconductor elements has been advancing. Consequently, resin-sealed semiconductor devices have shifted from conventional pin-insertion type packages to surface-mount type packages as the mainstream. Surface-mount type ICs (Integrated Circuits), LSIs (Large Scale Integrations), and the like have thin and compact packages in order to increase mounting density and reduce mounting height. As a result, the area occupied by elements relative to packages has increased, and the thickness of packages has become extremely thin.

Furthermore, these packages differ from pin-insertion type packages in their mounting method. That is, pin-insertion type packages have a structure in which the package is not directly exposed to high temperatures, because soldering is performed from the back surface of the wiring board after the pins are inserted into the wiring board.
However, since surface-mount type ICs are temporarily fixed to the surface of a wiring board and processed by a solder bath, a reflow device, and the like, the package is directly exposed to soldering temperatures (reflow temperatures). As a result, in the case where the package has absorbed moisture, the absorbed moisture vaporizes during reflow, and the generated vapor pressure acts as a peeling stress, causing delamination between support members such as elements and lead frames and the sealing material, which leads to package cracking and electrical characteristic defects. For this reason, development of a sealing material having superior adhesiveness to support members and, by extension, superior solder heat resistance (reflow resistance) is desired.

A curable resin composition including an epoxy resin, a curing agent, a curing accelerator, an inorganic filler, and an alkoxysilane polymer having a specific structure as a sealing material having superior reflow resistance has been proposed in Patent Document 1.
Further, for the purpose of improving reflow resistance, for example, roughening the surface of a lead frame prior to plating treatment has been performed in order to improve adhesiveness with the sealing material.

### Citation List

### Patent Documents

Patent Document 1: Japanese Patent Application Laid-Open (JP-A) No. 2008-111101.

### SUMMARY OF INVENTION

### Technical Problem

Development of a sealing material in which delamination from the lead frame is prevented even under more stringent moisture absorption conditions (for example, moisture absorption conditions of 85°C and 85% RH) is desired.
The disclosure has been made in consideration of the above circumstances, and is intended to provide a curable resin composition in which delamination from the lead frame is prevented even in the case where a cured product is subjected to moisture absorption under conditions of 85°C and 85% RH, and an electronic component device including an element sealed by the curable resin composition.

### Solution to Problem

<1> A curable resin composition is provided, which includes an epoxy resin,
   in which an adhesive strength of a cured product to AgCu at 260°C after heating and humidifying at 85°C and 85% RH for 168 hours is 0.40 MPa or more.
<2> In the curable resin composition according to <1>, a curing agent is further included, and an equivalent ratio of the curing agent to the epoxy resin, which is curing agent/epoxy resin, is 0.8 or less.
<3> In the curable resin composition according to <1> or <2>, a cured product has a glass transition temperature greater than 110°C.
<4> In the curable resin composition according to any one of <1> to <3>, a thermal expansion coefficient α2 measured at 180°C to 200°C is 32.0 ppm/°C or more.
<5> In the curable resin composition according to any one of <1> to <4>, the epoxy resin includes at least one selected from a group consisting of a triphenylmethane type epoxy resin containing a t-Bu group and a biphenyl epoxy resin.
<6> The curable resin composition according to any one of <1> to <5> further includes an inorganic filler.
<7> An electronic component device is provided, which includes:
   an element; and
   a cured product of the curable resin composition according to any one of <1> to <6>, sealing the element.
<8> The electronic component device according to <7> further includes a lead frame having the element mounted on one surface of the lead frame.
<9> In the electronic component device according to <8>, the lead frame contains Ag.

### Effects of Invention

According to the disclosure, it is possible to provide a curable resin composition in which peeling from the lead frame is prevented even in a case where the cured product absorbs moisture under conditions of 85°C and 85% RH, and an electronic component device including an element sealed by the curable resin composition.

### DESCRIPTION OF EMBODIMENTS

The following describes in detail the embodiments for implementing the disclosure. However, the disclosure is not limited to the following embodiments. In the following embodiments, the constituent elements (including element steps and the like) are not essential unless specifically indicated. The same applies to numerical values and ranges thereof, and they do not limit the disclosure.

In the disclosure, a numerical range indicated using "~" includes the values before and after "~" as the minimum and maximum values, respectively.
In the numerical ranges described stepwise in the disclosure, an upper limit value or lower limit value described in one numerical range may be replaced with an upper limit value or lower limit value of another stepwise described numerical range. Further, in the numerical ranges described in the disclosure, the upper limit value or lower limit value of the numerical range may be replaced with a value shown in the examples.
In the disclosure, each component may contain multiple types of corresponding compounds. In the case where multiple types of substances corresponding to each component exist in the composition, the content rate or content amount of each component means the total content rate or content amount of the multiple types of substances present in the composition, unless otherwise specified.
In the disclosure, particles corresponding to each component may include multiple types. In the case where multiple types of particles corresponding to each component exist in the composition, the particle diameter of each component means the value for the mixture of the multiple types of particles present in the composition, unless otherwise specified.
In the disclosure, the term "lamination" refers to stacking layers, and two or more layers may be bonded together, or two or more layers may be detachable.
In the disclosure, notation of groups (atomic groups) that does not describe substituted or unsubstituted includes both those having no substituent and those having a substituent.
In the disclosure, the number of structural units represents an integer value for a single molecule, but represents a rational number that is an average value for an aggregate of multiple types of molecules.
In the disclosure, the number of carbon atoms refers to the total number of carbon atoms contained in an entire group; in a case where the group has no substituent, it represents the number of carbon atoms forming the skeleton of the group, and in a case where the group has a substituent, it represents the total number obtained by adding the number of carbon atoms in the substituent to the number of carbon atoms forming the skeleton of the group.

In the disclosure, the weight average molecular weight (Mw) is a value measured using the GPC measurement device described below under the measurement conditions described below, and converted using a calibration curve of standard polystyrene. However, for compounds whose molecular weight is too low to allow accurate Mw measurement by GPC, the molecular weight determined from the chemical structure of the compound is adopted as the Mw, Mn, or degree of polymerization of the compound.
As an example of a measurement device, the following may be listed, and the calibration curve may be prepared using a 5-sample set of standard polystyrene ("PStQuick MP-H" and "PStQuick B", manufactured by Tosoh Corporation).

### (GPC Measurement Device)

GPC device: high-speed GPC device "HCL-8320GPC", detector is a differential refractometer or UV, manufactured by Tosoh Corporation
Column: column TSKgel SuperMultipore HZ-H (column length: 15 cm, column inner diameter: 4.6 mm), manufactured by Tosoh Corporation

### (Measurement Conditions)

Solvent: tetrahydrofuran (THF)
Measurement temperature: 40°C
Flow rate: 0.35 mL/min
Sample concentration: 10 mg/THF 5 mL
Injection volume: 20 µL

### <Curable Resin Composition>

The curable resin composition of the disclosure includes an epoxy resin, and a cured product thereof has an adhesive strength to AgCu of 0.40 MPa or more at 260°C after being heated and humidified at 85°C and 85% RH for 168 hours.

The curable resin composition of the disclosure has the aforementioned adhesive strength of 0.40 MPa or more, which prevents delamination of the cured product from the lead frame even in the case of moisture absorption of the cured product under conditions of 85°C and 85% RH for 168 hours, and makes it possible to greatly reduce the ratio of the cured product peeling from the lead frame relative to the number of packages.

### (Epoxy Resin)

The curable resin composition of the disclosure includes an epoxy resin.
The epoxy resin may be used alone or in combination of two or more types.

Examples of the epoxy resin include: novolac type epoxy resins obtained by epoxidation of novolac resins obtained by condensation or co-condensation of at least one phenolic compound selected from the group consisting of phenolic compounds such as phenol, cresol, xylenol, resorcinol, catechol, bisphenol A, and bisphenol F, and naphthol compounds such as α-naphthol, β-naphthol, and dihydroxynaphthalene, with aliphatic aldehyde compounds such as formaldehyde, acetaldehyde, and propionaldehyde, under an acidic catalyst (phenol novolac type epoxy resins, orthocresol novolac type epoxy resins, etc.); triphenylmethane-type epoxy resins obtained by epoxidizing triphenylmethane-type phenol resins produced by condensation or co-condensation under acidic catalyst of the aforementioned phenolic compounds with aromatic aldehyde compounds such as benzaldehyde, salicylaldehyde, etc.; copolymer-type epoxy resins obtained by epoxidizing novolac resins produced by co-condensation under acidic catalyst of the aforementioned phenol compounds and naphthol compounds with aldehyde compounds; diphenylmethane-type epoxy resins which are diglycidyl ethers of bisphenol A, bisphenol F, etc.; biphenyl type epoxy resins which are diglycidyl ethers of alkyl-substituted or unsubstituted biphenols; stilbene-type epoxy resins which are diglycidyl ethers of stilbene-based phenol compounds; sulfur atom-containing epoxy resins which are diglycidyl ethers of bisphenol S, etc.; epoxy resins which are glycidyl ethers of alcohols such as butanediol, polyethylene glycol, polypropylene glycol, etc.; glycidyl ester-type epoxy resins which are glycidyl esters of polyvalent carboxylic acid compounds such as phthalic acid, isophthalic acid, tetrahydrophthalic acid, etc.; glycidylamine-type epoxy resins in which active hydrogens bonded to nitrogen atoms of aniline, diaminodiphenylmethane, isocyanuric acid, etc. are substituted with glycidyl groups; dicyclopentadiene-type epoxy resins obtained by epoxidizing co-condensation resins of dicyclopentadiene and phenol compounds; alicyclic epoxy resins such as vinylcyclohexene diepoxide, 3,4-epoxycyclohexylmethyl-3,4-epoxycyclohexanecarboxylate, 2-(3,4-epoxy)cyclohexyl-5,5-spiro(3,4-epoxy)cyclohexane-m-dioxane, etc., in which olefin bonds in the molecule are epoxidized; paraxylylene-modified epoxy resins which are glycidyl ethers of paraxylylene-modified phenol resins; metaxylylene-modified epoxy resins which are glycidyl ethers of metaxylylene-modified phenol resins; terpene-modified epoxy resins which are glycidyl ethers of terpene-modified phenol resins; dicyclopentadiene-modified epoxy resins which are glycidyl ethers of dicyclopentadiene-modified phenol resins; cyclopentadiene-modified epoxy resins which are glycidyl ethers of cyclopentadiene-modified phenol resins; polycyclic aromatic ring-modified epoxy resins which are glycidyl ethers of polycyclic aromatic ring-modified phenol resins; naphthalene-type epoxy resins which are glycidyl ethers of naphthalene ring-containing phenol resins; halogenated phenol novolac-type epoxy resins; hydroquinone-type epoxy resins; trimethylolpropane-type epoxy resins; linear aliphatic epoxy resins obtained by oxidizing olefin bonds with peracids such as peracetic acid; aralkyl-type epoxy resins obtained by epoxidizing aralkyl phenol resins such as phenol aralkyl resins, naphthol aralkyl resins, etc. Further, aminophenol type epoxy resins that are glycidyl ethers of aminophenol and the like are also listed as epoxy resins.

The epoxy resin preferably includes at least one selected from the group consisting of a triphenylmethane type epoxy resin and a biphenyl epoxy resin, and more preferably includes at least one selected from the group consisting of a triphenylmethane type epoxy resin containing a t-Bu group (t-butyl group) and a biphenyl epoxy resin.

The epoxy resin preferably includes a triphenylmethane type epoxy resin, from the perspective of preventing delamination of the cured product of the curable resin composition from a support member (for example, a support member containing AgCu).

The triphenylmethane type epoxy resin preferably includes an epoxy resin having at least one selected from the group consisting of an alkyl group and an alkoxy group (hereinafter, also referred to as a specific triphenylmethane type epoxy resin).
When the triphenylmethane type epoxy resin has at least one selected from the group consisting of an alkyl group and an alkoxy group, the monomer becomes bulkier and the molecular weight of the monomer increases, resulting in a polymer with a wider intermolecular distance and a lower crosslink density after polymerization. For this reason, the number of molecules per unit volume decreases, and the molecules tend to disentangle under tensile stress, so a reduction in the elastic modulus and an increase in the linear expansion coefficient of the cured product of the curable resin composition are expected. As a result, the stress (a combination of strain, elastic modulus, linear expansion difference, and temperature difference) generated by the linear expansion difference between the support members is reduced to below the adhesive strength of the resin, thereby preventing delamination of the cured product of the curable resin composition from the support members. It is further inferred that reflow resistance is also improved accordingly.

The alkyl group of the specific triphenylmethane type epoxy resin preferably has 1 to 20 carbon atoms, more preferably 1 to 16 carbon atoms, and further preferably 1 to 10 carbon atoms. The alkyl group may be linear, branched, or cyclic; however, at least one alkyl group is preferably branched, and preferably includes a t-butyl group.

The alkoxy group of the specific triphenylmethane type epoxy resin preferably has 1 to 20 carbon atoms, more preferably 1 to 16 carbon atoms, and further preferably 1 to 10 carbon atoms. The alkoxy group may be linear, branched, or cyclic.

The benzene ring included in the specific triphenylmethane type epoxy resin preferably has two or more alkyl groups, and the benzene ring included in the main chain more preferably has two or more alkyl groups. At least one of the two or more alkyl groups of the benzene ring is preferably a branched alkyl group, and the branched alkyl group is preferably arranged at an ortho position relative to a glycidyloxy group.

The specific triphenylmethane type epoxy resin may be an epoxy resin represented by the following formula (1).

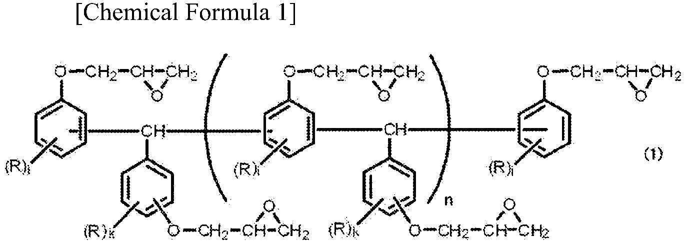

In formula (1), R each independently represents an alkyl group or an alkoxy group, i each independently represents an integer of 1 to 3, and k each independently represents an integer of 0 to 4. n is an average value and represents a number of 0 to 10.

Examples of the alkyl group and the alkoxy group represented by R include those described above.
i represents an integer of 1 to 3, preferably 2 or 3, and more preferably 2. In the case of i being 2, at least one of R represented by the subscript i is preferably a branched alkyl group, and more preferably a combination of a branched alkyl group and a linear alkyl group, examples of which include a combination of a t-butyl group and a methyl group. The t-butyl group and the methyl group may be arranged at any position on the benzene ring; however, the t-butyl group is preferably arranged at an ortho position relative to a glycidyloxy group. Further, the positional relationship between the t-butyl group and the methyl group may be any arrangement, and either of an ortho position, a meta position, or a para position may be selected.
k each independently represents an integer of 0 to 4, and is preferably 0.

Specific examples of the specific triphenylmethane type epoxy resin include an epoxy resin represented by the following formula (2). 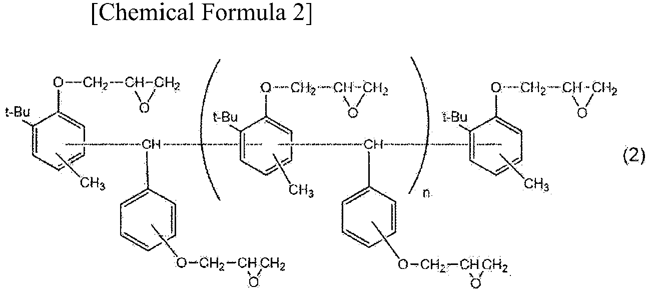 n is an average value and represents a number of 0 to 10.

The content rate of the specific triphenylmethane type epoxy resin is preferably 50% by mass to 100% by mass, more preferably 70% by mass to 100% by mass, and further preferably 90% by mass to 100% by mass, relative to the total amount of the triphenylmethane type epoxy resin.

Among the above epoxy resins, a biphenyl epoxy resin is preferably included from the perspective of the adhesiveness of the curable resin composition of the disclosure to the lead frame and from the perspective of the balance between heat resistance and fluidity.

The biphenyl epoxy resin is not particularly limited as long as it is an epoxy resin having a biphenyl skeleton. For example, an epoxy resin represented by the following general formula (II) is preferable.

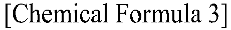

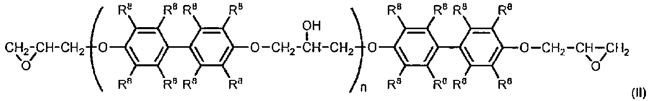

In formula (II), R⁸ represents a hydrogen atom, an alkyl group having 1 to 12 carbon atoms, or an aromatic group having 4 to 18 carbon atoms, and each may be the same or different. n is an average value and represents a number of 0 to 10.

The stilbene type epoxy resin is not particularly limited as long as it is an epoxy resin having a stilbene skeleton. For example, an epoxy resin represented by the following general formula (III) is preferable.

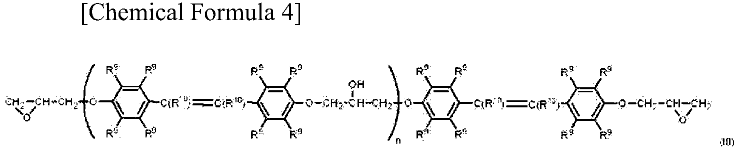

In formula (III), R⁹ and R¹⁰ each represent a hydrogen atom or a monovalent organic group having 1 to 18 carbon atoms, and each may be the same or different. n is an average value and represents a number of 0 to 10.

The diphenylmethane type epoxy resin is not particularly limited as long as it is an epoxy resin having a diphenylmethane skeleton. For example, an epoxy resin represented by the following general formula (IV) is preferable.

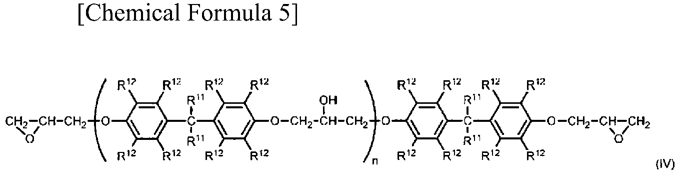

In formula (IV), R¹¹ and R¹² each represent a hydrogen atom or a monovalent organic group having 1 to 18 carbon atoms, and each may be the same or different. n is an average value and represents a number of 0 to 10.

The sulfur atom-containing type epoxy resin is not particularly limited as long as it is an epoxy resin containing a sulfur atom. For example, an epoxy resin represented by the following general formula (V) may be listed.

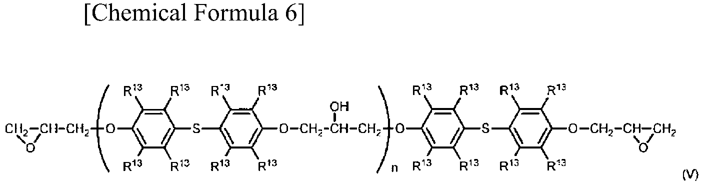

In formula (V), R¹³ represents a hydrogen atom or a monovalent organic group having 1 to 18 carbon atoms, and each may be the same or different. n is an average value and represents a number of 0 to 10.

The novolac type epoxy resin is not particularly limited as long as it is an epoxy resin obtained by epoxidation of a novolac type phenolic resin. For example, an epoxy resin represented by the following general formula (VI) may be listed.

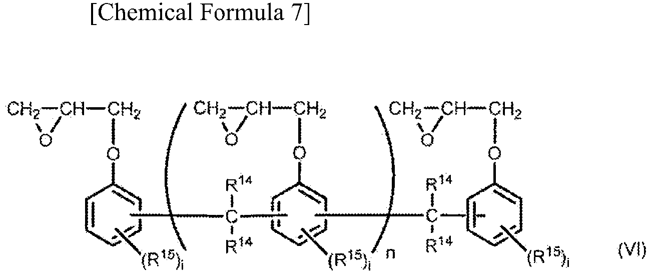

In formula (VI), R¹⁴ represents a hydrogen atom or a monovalent organic group having 1 to 18 carbon atoms, and each may be the same or different. R¹⁵ represents a monovalent organic group having 1 to 18 carbon atoms, and each may be the same or different. i each independently represents an integer of 0 to 3. n is an average value and represents a number of 0 to 10.

The dicyclopentadiene type epoxy resin is not particularly limited as long as it is an epoxy resin obtained by epoxidation using a compound having a dicyclopentadiene skeleton as a raw material. For example, an epoxy resin represented by the following general formula (VII) may be listed.

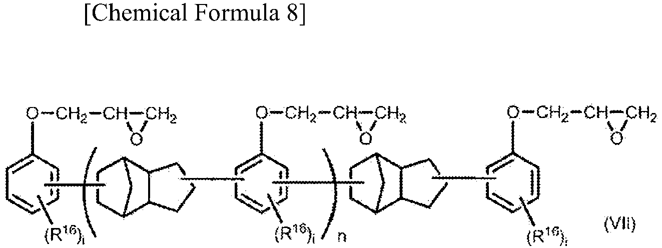

In formula (VII), R¹⁶ represents a monovalent organic group having 1 to 18 carbon atoms, and each may be the same or different. i each independently represents an integer of 0 to 3. n is an average value and represents a number of 0 to 10.

The copolymerization type epoxy resin obtained by epoxidation of a novolac resin derived from a naphthol compound and a phenolic compound with an aldehyde compound is not particularly limited as long as it is an epoxy resin using a compound having a naphthol skeleton and a compound having a phenol skeleton as raw materials. For example, an epoxy resin represented by the following general formula (IX) may be listed.

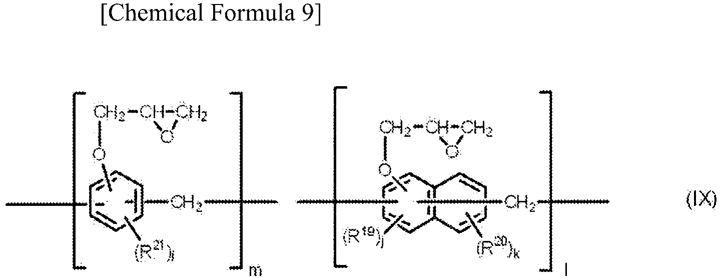

In formula (IX), R¹⁹ to R²¹ each represent a monovalent organic group having 1 to 18 carbon atoms, and each may be the same or different. i each independently represents an integer of 0 to 3, j each independently represents an integer of 0 to 2, and k each independently represents an integer of 0 to 4. 1 and m are each an average value and represent a number of 0 to 10, and (l+m) represents a number of 0 to 10. The terminal of the epoxy resin represented by formula (IX) is either one of the following formula (IX-1) or (IX-2). In formula (IX-1) and (IX-2), the definitions of R¹⁹ to R²¹, i, j, and k are the same as the definitions of R¹⁹ to R²¹, i, j, and k in formula (IX). n is 1 (in the case of bonding via a methylene group) or 0 (in the case of bonding without a methylene group).

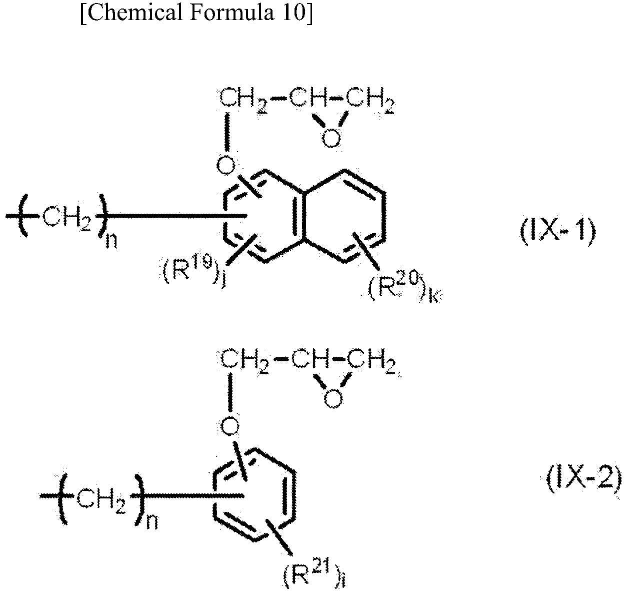

Examples of the epoxy resin represented by the above general formula (IX) include a random copolymer containing l structural units and m structural units randomly, an alternating copolymer containing the same alternately, a copolymer containing the same regularly, and a block copolymer containing the same in blocks. Any one of these may be used alone, or two or more of these may be used in combination.

As the copolymerization type epoxy resin, Epiclon HP-5000 (DIC Corporation, trade name), which is a methoxynaphthylene-cresol formaldehyde co-condensation type epoxy resin containing the following two types of structural units in a random, alternating, or block order, is also preferable. For example, an epoxy resin represented by the following general formula may be listed. In the following general formula, n and m are each an average value and represent a number of 0 to 10, and (n+m) represents a number of 0 to 10, and preferably n and m are each an average value and represent a number of 1 to 9, and (n+m) represents a number of 2 to 10.

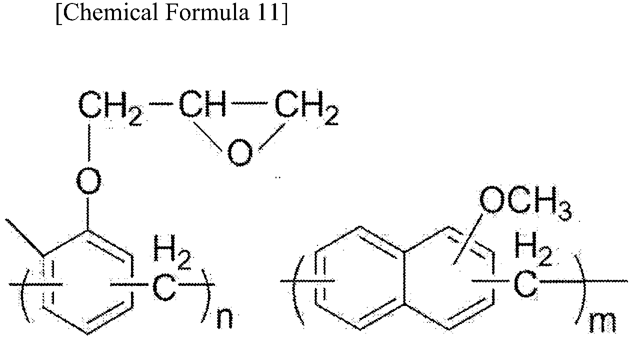

The aralkyl type epoxy resin is not particularly limited as long as it is an epoxy resin using, as a raw material, a phenolic resin synthesized from at least one selected from the group consisting of phenolic compounds such as phenol and cresol and naphthol compounds such as naphthol and dimethylnaphthol, and dimethoxypara-xylene, bis(methoxymethyl)biphenyl, or derivatives thereof. For example, an epoxy resin obtained by glycidyl etherification of a phenolic resin synthesized from at least one selected from the group consisting of phenolic compounds such as phenol and cresol and naphthol compounds such as naphthol and dimethylnaphthol, and dimethoxypara-xylene, bis(methoxymethyl)biphenyl, or derivatives thereof is preferable, and epoxy resins represented by the following general formulae (X) and (XI) are more preferable.

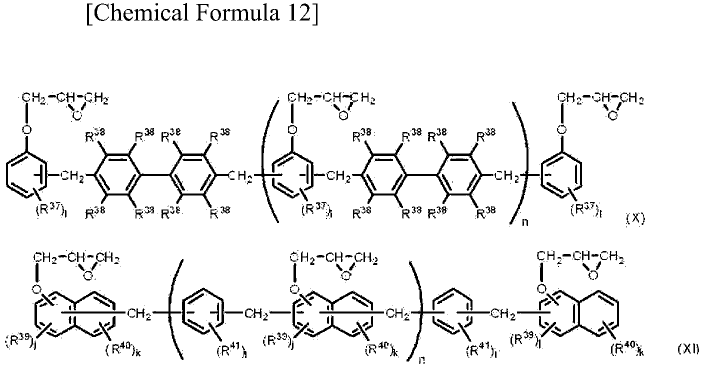

In formulae (X) and (XI), R³⁸ represents a hydrogen atom or a monovalent organic group having 1 to 18 carbon atoms, and each may be the same or different. R³⁷, R³⁹ to R⁴¹ each represent a monovalent organic group having 1 to 18 carbon atoms, and each may be the same or different. i each independently represents an integer of 0 to 3, j each independently represents an integer of 0 to 2, k each independently represents an integer of 0 to 4, and l each independently represents an integer of 0 to 4. n is an average value and each independently represents a number of 0 to 10.

In the above general formulae (II) to (VII), (IX) to (XI), regarding R⁸ to R²¹ and R³⁷ to R⁴¹, "each may be the same or different" means, for example, in formula (II) that all 8 to 88 R⁸ groups in the formula may be the same or different. For the other R⁹ to R²¹ and R³⁷ to R⁴¹, it means that all of the respective numbers contained in the formula may be the same or different. In addition, R⁸ to R²¹ and R³⁷ to R⁴¹ may each be the same or different. For example, all of R⁹ and R¹⁰ may be the same or different.
Further, the monovalent organic group having 1 to 18 carbon atoms in general formulae (III) to (VII), (IX) to (XI) is preferably an alkyl group or an aryl group.

In the above general formulae (II) to (VII), (IX) to (XI), n is an average value and is preferably in the range of 0 to 10 independently of each other. In the case where n is 10 or less, the melt viscosity of the resin component does not become excessively high, the viscosity of the curable resin composition during melt molding decreases, and the occurrence of poor filling, deformation of bonding wires (gold wires connecting the element and leads), and the like tends to be reduced. n is more preferably set in the range of 0 to 4.

The epoxy equivalent of the epoxy resin is not particularly limited. From the viewpoint of balancing various properties such as moldability, heat resistance, and electrical reliability, the epoxy equivalent of the epoxy resin is preferably 40 g/eq to 1000 g/eq, more preferably 45 g/eq to 500 g/eq, and further preferably 50 g/eq to 350 g/eq.
The epoxy equivalent of the epoxy resin is defined as the value measured according to the method conforming to JIS K 7236:2009.

The epoxy resin may be solid or liquid at 25°C. In the case where the epoxy resin is solid at 25°C, the softening point or melting point of the epoxy resin is not particularly limited. From the viewpoint of balancing moldability and heat resistance, the softening point or melting point of the epoxy resin is preferably 40°C to 180°C. Further, from the viewpoint of handleability during production of the curable resin composition, the softening point or melting point of the epoxy resin is preferably 50°C to 130°C.
In the disclosure, the softening point refers to a value measured by the ring-and-ball method of JIS K 7234:1986.
In the disclosure, the melting point refers to a value measured in accordance with the visual method of JIS K 0064:1992.

From the viewpoint of balancing moldability and heat resistance, the weight average molecular weight (Mw) of the epoxy resin is preferably 550 to 1050, and more preferably 650 to 950.

The proportion of the triphenylmethane type epoxy resin relative to 100 parts by mass of the total amount of the epoxy resin in the curable resin composition is preferably 15 parts by mass or more, more preferably 20 parts by mass or more, and further preferably 25 parts by mass or more. The upper limit of the proportion is not particularly limited, and may be 95 parts by mass or less, 90 parts by mass or less, 85 parts by mass or less, or 50 parts by mass or less.

The proportion of the biphenyl epoxy resin relative to 100 parts by mass of the total amount of the epoxy resin in the curable resin composition is preferably 5 parts by mass or more, more preferably 10 parts by mass or more, and further preferably 15 parts by mass or more. The upper limit of the proportion is not particularly limited, and may be 50 parts by mass or less, 40 parts by mass or less, or 30 parts by mass or less.

The total content rate of the epoxy resin in the curable resin composition is preferably 0.5% by mass to 60% by mass, more preferably 2% by mass to 50% by mass, and further preferably 3% by mass to 45% by mass, from the viewpoint of strength, fluidity, heat resistance, moldability, and the like.

### (Curing agent)

The curable resin composition of the disclosure preferably includes a curing agent. The type of the curing agent is not particularly limited, and may be selected from those generally used as components of a curable resin composition. The curing agent may be used alone or in combination of two or more types.
In the disclosure, the curing agent refers to any compound having a structure capable of reacting with the epoxy resin contained in the curable resin composition and curing the curable resin composition, and even a compound having a low content and a low contribution to the curing reaction of the curable resin composition is included in the curing agent.

Examples of the curing agent include a phenolic curing agent, an amine curing agent, an acid anhydride curing agent, a polymercaptan curing agent, a polyaminoamide curing agent, an isocyanate curing agent, a blocked isocyanate curing agent, and the like.
Among these, the curing agent is preferably a phenolic curing agent or an amine curing agent from the viewpoint of heat resistance. Further, the curing agent is preferably a phenolic curing agent from the viewpoint of adhesiveness of the curable resin composition of the disclosure to the lead frame and the viewpoint of heat resistance.

Examples of phenolic curing agents include phenol resins and polyhydric phenol compounds having two or more phenolic hydroxyl groups in one molecule. Specific examples include polyhydric phenol compounds such as resorcinol, catechol, bisphenol A, bisphenol F, substituted or unsubstituted biphenol, etc.; novolac-type phenol resins obtained by condensation or co-condensation under acidic catalyst of at least one phenolic compound selected from the group consisting of phenol compounds such as phenol, cresol, xylenol, resorcinol, catechol, bisphenol A, bisphenol F, phenylphenol, aminophenol, and naphthol compounds such as α-naphthol, β-naphthol, dihydroxynaphthalene, with aldehyde compounds such as formaldehyde, acetaldehyde, propionaldehyde; aralkyl phenol resins such as phenol aralkyl resins and naphthol aralkyl resins synthesized from the aforementioned phenolic compounds and compounds such as dimethoxy paraxylene, bis(methoxymethyl)biphenyl; para-xylylene and/or meta-xylylene-modified phenolic resins; melamine-modified phenol resins; terpene-modified phenol resins; dicyclopentadiene-type phenol resins and dicyclopentadiene-type naphthol resins synthesized by copolymerization of the aforementioned phenolic compounds with dicyclopentadiene; cyclopentadiene-modified phenol resins; polycyclic aromatic ring-modified phenol resins; biphenyl-type phenol resins; triphenylmethane type phenol resins obtained by condensing or co-condensing the above phenolic compounds with aromatic aldehyde compounds such as benzaldehyde and salicylaldehyde under an acidic catalyst; phenol resins obtained by copolymerizing two or more of these, and the like. These phenolic curing agents may be used alone or in combination of two or more types.

Examples of the aralkyl phenol resin include phenol aralkyl resins and naphthol aralkyl resins synthesized from a phenolic compound and dimethoxy-para-xylene, bis(methoxymethyl)biphenyl, and the like. The aralkyl phenol resin may further be copolymerized with other phenolic resins. Examples of the copolymerized aralkyl phenol resin include a copolymerization type phenolic resin of a triphenylmethane type phenolic resin and an aralkyl phenol resin, a copolymerization type phenolic resin of a salicylaldehyde type phenolic resin and an aralkyl phenol resin, and a copolymerization type phenolic resin of a novolac type phenolic resin and an aralkyl phenol resin.

The aralkyl phenol resin is not particularly limited as long as it is a phenolic resin synthesized from at least one selected from the group consisting of phenolic compounds and naphthol compounds, and dimethoxy-para-xylene, bis(methoxymethyl)biphenyl, or derivatives thereof.
For example, phenolic resins represented by the following general formulae (XII) to (XIV) are preferable.

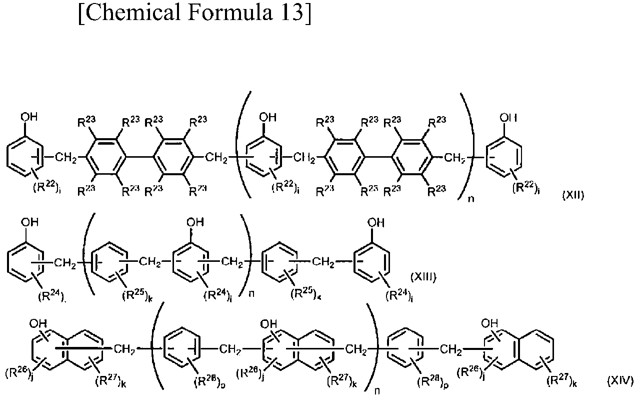

In formulae (XII) to (XIV), R²³ represents a hydrogen atom or a monovalent organic group having 1 to 18 carbon atoms, and each may be the same or different. R²², R²⁴, R²⁵, and R²⁸ represent a monovalent organic group having 1 to 18 carbon atoms, and each may be the same or different. R²⁶ and R²⁷ represent a hydroxyl group or a monovalent organic group having 1 to 18 carbon atoms, and each may be the same or different. i is each independently an integer of 0 to 3, j is each independently an integer of 0 to 2, k is each independently an integer of 0 to 4, and p is each independently an integer of 0 to 4. n is an average value and each independently represents a number of 0 to 10.

From the viewpoint of adhesiveness of the curable resin composition of the disclosure to the lead frame and the viewpoint of heat resistance, the aralkyl phenol resin is preferably a phenolic resin represented by general formula (XIII).
From the viewpoint of adhesiveness of the curable resin composition of the disclosure to the lead frame and the viewpoint of heat resistance, it is also preferable that i and k in general formula (XIII) are both 0.

The dicyclopentadiene type phenolic resin is not particularly limited as long as it is a phenolic resin obtained using a compound having a dicyclopentadiene skeleton as a raw material. For example, a phenolic resin represented by the following general formula (XV) may be listed.

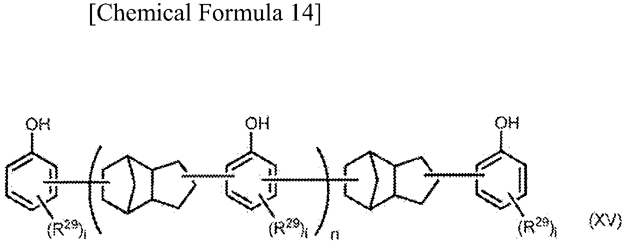

In formula (XV), R²⁹ represents a monovalent organic group having 1 to 18 carbon atoms, and each may be the same or different. i each independently represents an integer of 0 to 3. n is an average value and represents a number of 0 to 10.

The triphenylmethane type phenolic resin is not particularly limited as long as it is a phenolic resin obtained using an aromatic aldehyde compound as a raw material. For example, a phenolic resin represented by the following general formula (XVI) is preferable.

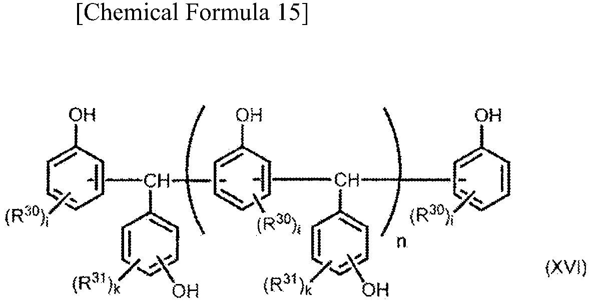

In formula (XVI), R³⁰ and R³¹ represent a monovalent organic group having 1 to 18 carbon atoms, and each may be the same or different. i is each independently an integer of 0 to 3, and k is each independently an integer of 0 to 4. n is an average value and represents a number of 0 to 10.

The copolymerization type phenolic resin of a triphenylmethane type phenolic resin and an aralkyl phenol resin is not particularly limited as long as it is a copolymerization type phenolic resin of a phenolic resin obtained using a compound having a benzaldehyde skeleton as a raw material and an aralkyl phenol resin. For example, a phenolic resin represented by the following general formula (XVII) is preferable.

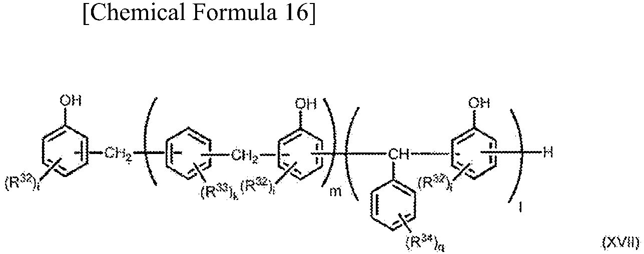

In formula (XVII), R³² to R³⁴ represent a monovalent organic group having 1 to 18 carbon atoms, and each may be the same or different. i is each independently an integer of 0 to 3, k is each independently an integer of 0 to 4, and q is each independently an integer of 0 to 5. l and m are each an average value and each independently represents a number of 1 to 11.

The novolac type phenolic resin is not particularly limited as long as it is a phenolic resin obtained by condensation or co-condensation of at least one phenolic compound selected from the group consisting of a phenolic compound and a naphthol compound with an aldehyde compound under an acidic catalyst. For example, a phenolic resin represented by the following general formula (XVIII) is preferable.

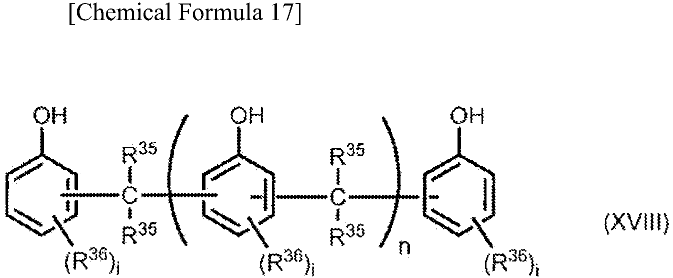

In formula (XVIII), R³⁵ represents a hydrogen atom or a monovalent organic group having 1 to 18 carbon atoms, and each may be the same or different. R³⁶ represents a monovalent organic group having 1 to 18 carbon atoms, and each may be the same or different. i each independently represents an integer of 0 to 3. n is an average value and represents a number of 0 to 10.

The phrase "each may be the same or different" described for R²² to R³⁶ in the above general formulae (XII) to (XVIII) means, for example, that all i R²² groups in formula (XII) may be the same or different from each other. For the other R²³ to R³⁶, it means that all of the respective numbers included in the formulae may be the same or different from each other. In addition, R²² to R³⁶ may each be the same or different. For example, all of R²² and R²³ may be the same or different, and all of R³⁰ and R³¹ may be the same or different.

In the above general formulae (XII) to (XVIII), n is preferably in the range of 0 to 10. In the case where n is not more than 10, the melt viscosity of the resin component does not become too high, the viscosity of the curable resin composition during melt molding also decreases, and filling defects and deformation of bonding wires (gold wires connecting the element and leads) are less likely to occur. The average n per molecule is preferably set in the range of 0 to 4.

Specific examples of the amine curing agent include aliphatic amine compounds such as diethylenetriamine, triethylenetetramine, n-propylamine, 2-hydroxyethylaminopropylamine, cyclohexylamine, and 4,4'-diamino-dicyclohexylmethane; aromatic amine compounds such as diethyltoluenediamine, 3,3'-diethyl-4,4'-diaminodiphenylmethane, dimethylthiotoluenediamine, and 2-methylaniline; imidazole compounds such as imidazole, 2-methylimidazole, 2-ethylimidazole, and 2-isopropylimidazole; and imidazoline compounds such as imidazoline, 2-methylimidazoline, and 2-ethylimidazoline.

The functional group equivalent of the curing agent (hydroxyl group equivalent in the case of a phenolic curing agent, and active hydrogen equivalent in the case of an amine curing agent) is not particularly limited. From the viewpoint of balance of various properties such as moldability, heat resistance, and electrical reliability, it is preferably 10 g/eq to 1000 g/eq, and more preferably 30 g/eq to 500 g/eq.
The hydroxyl group equivalent in the case of a phenolic curing agent refers to a value calculated based on the hydroxyl value measured in accordance with JIS K 0070:1992. Further, the active hydrogen equivalent in the case of an amine curing agent refers to a value calculated based on the amine value measured in accordance with JIS K 7237:1995.

In the case where the curing agent is a solid at 25°C, the softening point or melting point thereof is not particularly limited. From the viewpoint of moldability and heat resistance, the softening point or melting point of the curing agent is preferably 40°C to 180°C. From the viewpoint of handleability during production of the curable resin composition, the softening point or melting point of the curing agent is preferably 50°C to 130°C.

In the case where the curing agent is a phenolic curing agent, the equivalent ratio of the phenolic hydroxyl groups (active hydrogen) of the phenolic curing agent to the epoxy groups of the epoxy resin in the curable resin composition (number of moles of phenolic hydroxyl groups (active hydrogen) of the phenolic curing agent / number of moles of epoxy groups of the epoxy resin) is not particularly limited, and may be, for example, 0.5 to 1.2, may be 0.5 or more and less than 1.0, may be 0.55 to 0.9, or may be 0.6 to 0.8.
In the case where the equivalent ratio is set to 0.5 or more and less than 1.0, the adhesiveness between the cured product of the curable resin composition and the support member tends to improve. The reason for this is not clear; however, the value of tan δ near the reflow temperature may be increased, and the internal stress of the cured resin product during reflow tends to be relaxed.
From the viewpoint of improving the adhesiveness between the cured product of the curable resin composition and the support member, the equivalent ratio is preferably 0.8 or less, and more preferably 0.75 or less.

In the case where the curing agent includes a phenolic curing agent, from the viewpoint of the adhesiveness of the curable resin composition of the disclosure to a lead frame, the content rate of the phenolic curing agent relative to the total mass of the curing agent is preferably 50% by mass to 100% by mass, more preferably 60% by mass to 100% by mass, and further preferably 70% by mass to 100% by mass.

In the case where the phenolic curing agent includes an aralkyl phenol resin, from the viewpoint of the adhesiveness of the curable resin composition of the disclosure to a lead frame, the content rate of the aralkyl phenol resin relative to the total mass of the phenolic curing agent may be greater than 0% by mass and not more than 100% by mass, or may be 50% by mass to 70% by mass or 80% by mass to 100% by mass. The phenolic curing agent may not include an aralkyl phenol resin.

In the case where the phenolic curing agent includes a triphenylmethane type phenolic resin, from the viewpoint of the adhesiveness of the curable resin composition of the disclosure to a lead frame, the content rate of the triphenylmethane type phenolic resin relative to the total mass of the phenolic curing agent may be greater than 0% by mass and not more than 90% by mass, or may be 20% by mass to 50% by mass or 70% by mass to 90% by mass.

### (Inorganic filler)

The curable resin composition of the disclosure may include an inorganic filler. By including an inorganic filler in the curable resin composition, the hygroscopicity of the curable resin composition tends to be reduced and the strength in a cured state tends to improve. In the case where the curable resin composition is used as a sealing material for a semiconductor package, it is preferable to include an inorganic filler.

The inorganic material constituting the inorganic filler is not particularly limited. Specific examples of the inorganic material include spherical silica, crystalline silica, glass, alumina, calcium carbonate, zirconium silicate, calcium silicate, silicon nitride, aluminum nitride, boron nitride, aluminum nitride, boehmite, beryllia, magnesium oxide, zirconia, zircon, forsterite, steatite, spinel, mullite, titania, talc, clay, mica, titanate, and the like.
An inorganic filler composed of an inorganic material having a flame retardant effect may be used. Examples of the inorganic material having a flame retardant effect include aluminum hydroxide, magnesium hydroxide, composite metal hydroxides such as composite hydroxides of magnesium and zinc, zinc borate, and the like.
The inorganic filler may be used alone as one type or in combination of two or more types.

The shape of the inorganic filler is not particularly limited, and examples thereof include powdery, spherical, fibrous, and the like. From the viewpoint of the fluidity of the curable resin composition during molding and mold wear, a spherical shape is preferable.

The average particle diameter of the inorganic filler is not particularly limited. From the viewpoint of balancing the viscosity and fillability of the curable resin composition, the volume average particle diameter of the inorganic filler is preferably 0.1 µm to 50 µm, more preferably 0.3 µm to 30 µm, and further preferably 0.5 µm to 25 µm.
The volume average particle diameter of the inorganic filler may be measured as volume average particle diameter (D50) by a laser diffraction particle diameter distribution analyzer.

The particle diameter of the inorganic filler may be top-cut, may be top-cut at 100 µm or less, or may be top-cut at 75 µm or less.
The top-cut particle diameter may be determined from the particle size distribution obtained when measuring the volume average particle diameter (D50) described above.

In the case where the curable resin composition contains the inorganic filler, the content rate thereof is not particularly limited. The content rate of the inorganic filler relative to the total curable resin composition is preferably 30% by mass to 90% by mass, more preferably 35% by mass to 80% by mass, and further preferably 40% by mass to 70% by mass.
When the content rate of the inorganic filler is 30% by mass or more relative to the total curable resin composition, properties such as the thermal expansion coefficient, thermal conductivity, and elastic modulus of the cured product tend to be further improved. When the content rate of the inorganic filler is 90% by mass or less relative to the total curable resin composition, an increase in the viscosity of the curable resin composition is prevented, and the fluidity tends to be further improved, resulting in better moldability.

The content rate of the inorganic filler relative to the total curable resin composition is preferably 68% by volume to 86% by volume, more preferably 70% by volume to 84% by volume, and further preferably 72% by volume to 82% by volume.
When the content rate of the inorganic filler is 68% by volume or more relative to the total curable resin composition, properties such as the thermal expansion coefficient, thermal conductivity, and elastic modulus of the cured product tend to be further improved. When the content rate of the inorganic filler is 86% by volume or less relative to the total curable resin composition, an increase in the viscosity of the curable resin composition is prevented, and the fluidity tends to be further improved, resulting in better moldability.

### (Curing accelerator)

The curable resin composition of the disclosure may contain a curing accelerator. The type of the curing accelerator is not particularly limited, and may be selected according to the type of the epoxy resin, the desired properties of the curable resin composition, and the like. The curing accelerator may be used alone or in combination of two or more types. Specific examples of the curing accelerator are described below, but are not limited thereto.
Examples of the curing accelerator include diazabicycloalkenes such as 1,5-diazabicyclo[4.3.0]nonene-5 (DBN) and 1,8-diazabicyclo[5.4.0]undecene-7 (DBU); cyclic amidine compounds such as 2-methylimidazole, 2-phenylimidazole, 2-phenyl-4-methylimidazole, and 2-heptadecylimidazole; derivatives of the aforementioned cyclic amidine compounds; phenol novolac salts of the aforementioned cyclic amidine compounds or their derivatives; compounds having intramolecular polarization formed by adding compounds with π-bonds such as quinone compounds like maleic anhydride, 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, phenyl-1,4-benzoquinone, and diazophenylmethane to these compounds; cyclic amidinium compounds such as tetraphenylborate salt of DBU, tetraphenylborate salt of DBN, 2-ethyl-4-methylimidazole, N-methylmorpholine; tertiary amine compounds such as pyridine, triethylamine, triethylenediamine, benzyldimethylamine, triethanolamine, dimethylaminoethanol, tris(dimethylaminomethyl)phenol; derivatives of the aforementioned tertiary amine compounds; ammonium salt compounds such as tetra-n-butylammonium acetate, tetra-n-butylammonium phosphate, tetraethylammonium acetate, tetra-n-hexylammonium benzoate, tetrapropylammonium hydroxide; organic phosphines such as primary phosphines like ethylphosphine and phenylphosphine, secondary phosphines like dimethylphosphine and diphenylphosphine, tertiary phosphines like triphenylphosphine, diphenyl(p-tolyl)phosphine, tris(alkylphenyl)phosphine, tris(alkoxyphenyl)phosphine, tris(alkyl·alkoxyphenyl)phosphine, tris(dialkylphenyl)phosphine, tris(trialkylphenyl)phosphine, tris(tetraalkylphenyl)phosphine, tris(dialkoxyphenyl)phosphine, tris(trialkoxyphenyl)phosphine, tris(tetraalkoxyphenyl)phosphine, trialkylphosphine, dialkylalylphosphine, alkyldiarylphosphine, trinaphthylphosphine, tris(benzyl)phosphine; phosphine compounds such as complexes of the aforementioned organic phosphines with organic boron compounds; compounds having intramolecular polarization formed by adding compounds with π-bonds such as maleic anhydride, 1,4-benzoquinone, 2,5-toluquinone, 1,4-naphthoquinone, 2,3-dimethylbenzoquinone, 2,6-dimethylbenzoquinone, 2,3-dimethoxy-5-methyl-1,4-benzoquinone, 2,3-dimethoxy-1,4-benzoquinone, phenyl-1,4-benzoquinone, anthraquinone, and diazophenylmethane to the aforementioned organic phosphines or phosphine compounds; compounds having intramolecular polarization obtained through a dehydrohalogenation process after reacting the aforementioned organic phosphines or phosphine compounds with halogenated phenol compounds such as 4-bromophenol, 3-bromophenol, 2-bromophenol, 4-chlorophenol, 3-chlorophenol, 2-chlorophenol, 4-iodophenol, 3-iodophenol, 2-iodophenol, 4-bromo-2-methylphenol, 4-bromo-3-methylphenol, 4-bromo-2,6-dimethylphenol, 4-bromo-3,5-dimethylphenol, 4-bromo-2,6-di-butylphenol, 4-chloro-1-naphthol, 1-bromo-2-naphthol, 6-bromo-2-naphthol, 4-bromo-4'-hydroxybiphenyl; tetrasubstituted phosphonium compounds such as tetrasubstituted phosphonium including tetraphenylphosphonium, tetraphenylborate salts of tetrasubstituted phosphonium such as tetraphenylphosphonium tetra-p-tolylborate, and salts of tetrasubstituted phosphonium with phenol compounds; phosphobetaine compounds; adducts of phosphonium compounds and silane compounds; and the like.
Examples of suitable curing accelerators include triphenylphosphine and adducts of triphenylphosphine with quinone compounds.

In the case where the curable resin composition contains a curing accelerator, the content of the curing accelerator is preferably 0.1% by mass to 8% by mass, more preferably 0.3% by mass to 7% by mass, and further preferably 0.5% by mass to 6% by mass, relative to 100 parts by mass of the total amount of the epoxy resin and the curing agent. By setting the content of the curing accelerator within the above numerical range, the curing rate of the curable resin composition of the disclosure becomes an appropriate value, and production of molded articles is facilitated.

### (Various Additives)

The curable resin composition of the disclosure may contain, in addition to the above-described components, various additives such as a coupling agent, a stress relaxation agent, a mold release agent, a colorant, a flame retardant, an ion exchanger, and an ultraviolet absorber. The curable resin composition of the disclosure may also contain a siloxane compound having structural units with an epoxy group and an alkoxy group and having a degree of polymerization of 2. The curable resin composition may contain various additives known in the art as needed, in addition to the additives exemplified below.

### (Coupling agent)

The curable resin composition of the disclosure may contain a coupling agent. The type of the coupling agent is not particularly limited, and a known coupling agent may be used. Examples of the coupling agent include silane coupling agents and titanium coupling agents. The coupling agents may be used alone or in combination of two or more types.

The silane coupling agent is not particularly limited, and examples thereof include methyltrimethoxysilane, bis(3-(triethoxysilyl)propyl)tetrasulfide, 3-glycidoxypropyltrimethoxysilane, 3-glycidoxypropyltriethoxysilane, 3-glycidoxypropylmethyldiethoxysilane, 3-glycidoxypropylmethyldimethoxysilane, 2-(3,4-epoxycyclohexyl)ethyltrimethoxysilane, 3-aminopropyltriethoxysilane, 3-(2-aminoethyl)aminopropyltrimethoxysilane, 3-(2-aminoethyl)aminopropyltriethoxysilane, 3-aminopropyltrimethoxysilane, N-phenyl-3-aminopropyltrimethoxysilane, 3-mercaptopropyltrimethoxysilane, 3-mercaptopropyltriethoxysilane, 3-ureidopropyltriethoxysilane, octenyltrimethoxysilane, glycidoxyoctyltrimethoxysilane, and methacryloxyoctyltrimethoxysilane.

Examples of the titanium coupling agent include isopropyltriisostearoyl titanate, isopropyltris(dioctylpyrophosphate) titanate, isopropyltri(N-aminoethyl-aminoethyl) titanate, tetraoctylbis(ditridecylphosphite) titanate, tetra(2,2-diallyloxymethyl-1-butyl)bis(ditridecylphosphite) titanate, bis(dioctylpyrophosphate)oxyacetate titanate, bis(dioctylpyrophosphate)ethylene titanate, isopropyltrioctanoyl titanate, isopropyldimethacrylisostearoyl titanate, isopropyltridodecylbenzenesulfonyl titanate, isopropylisostearoyldiacryl titanate, isopropyltri(dioctylphosphate) titanate, isopropyltricumylphenyl titanate, and tetraisopropylbis(dioctylphosphite) titanate.

In the case where the curable resin composition contains a coupling agent, the content of the coupling agent is preferably 0.001 parts by mass to 10 parts by mass, more preferably 0.01 parts by mass to 8 parts by mass, and further preferably 0.05 parts by mass to 5 parts by mass, relative to 100 parts by mass of the inorganic filler contained in the curable resin composition, from the viewpoint of the adhesiveness at the interface between the epoxy resin and the inorganic filler.

### (Stress relaxation agent)

The curable resin composition of the disclosure may contain a stress relaxation agent such as silicone oil and silicone rubber particles. By the curable resin composition containing a stress relaxation agent, warpage deformation of the package and occurrence of package cracks may be further reduced. Examples of the stress relaxation agent include commonly used known stress relaxation agents (flexibilizers). Specifically, examples of the stress relaxation agent include thermoplastic elastomers such as silicone-based, styrene-based, olefin-based, urethane-based, polyester-based, polyether-based, polyamide-based, and polybutadiene-based elastomers; rubber particles such as natural rubber (NR), acrylonitrile-butadiene copolymer (NBR), acrylic rubber, urethane rubber, and silicone powder; and rubber particles having a core-shell structure such as methyl methacrylate-styrene-butadiene copolymer (MBS), methyl methacrylate-silicone copolymer, and methyl methacrylate-butyl acrylate copolymer. The stress relaxation agent may be used alone as one type, or two or more types may be used in combination. Among these, a silicone-based stress relaxation agent is preferable. Examples of the silicone-based stress relaxation agent include those having an epoxy group, those having an amino group, and those obtained by polyether modification of these.

In the case where the curable resin composition contains a stress relaxation agent, the content thereof is preferably 10 parts by mass to 60 parts by mass, and more preferably 20 parts by mass to 50 parts by mass, relative to 100 parts by mass of the epoxy resin contained in the curable resin composition.

### (Mold Release agent)

The curable resin composition of the disclosure may contain a mold release agent from the viewpoint of releasability from a mold in the case where a mold is used during molding. The mold release agent is not particularly limited, and conventionally known ones may be used. Examples of the mold release agent include carnauba wax, higher fatty acids such as montanic acid, and stearic acid; higher fatty acid metal salts; ester-based waxes such as montanic acid esters; and polyolefin-based waxes such as oxidized polyethylene and non-oxidized polyethylene. The mold release agent may be used alone as one type, or two or more types may be used in combination.

In the case where the curable resin composition of the disclosure contains a mold release agent, the content of the mold release agent is preferably 0.01 parts by mass to 15 parts by mass, and more preferably 0.1 parts by mass to 10 parts by mass, relative to 100 parts by mass of the epoxy resin contained in the curable resin composition. In the case where the amount of the mold release agent is 0.01 parts by mass or more relative to 100 parts by mass of the resin component, sufficient releasability tends to be obtained. In the case where the amount is 15 parts by mass or less, better releasability tends to be obtained.

### (Colorant)

The curable resin composition of the disclosure may contain a colorant. Examples of the colorant include known colorants such as carbon black, organic dyes, organic pigments, titanium oxide, red lead, and red iron oxide. The content of the colorant may be appropriately selected according to the intended purpose and the like. The colorant may be used alone as one type, or two or more types may be used in combination.

In the case where the curable resin composition contains a colorant, the content rate thereof is preferably 0.01% by mass to 5% by mass, and more preferably 0.05% by mass to 4% by mass.

### (Flame retardant)

The curable resin composition of the disclosure may contain a flame retardant. The flame retardant is not particularly limited, and conventionally known ones may be used. Examples of the flame retardant include organic or inorganic compounds containing a halogen atom, an antimony atom, a nitrogen atom, or a phosphorus atom, and metal hydroxides. The flame retardant may be used alone as one type, or two or more types may be used in combination.

In the case where the curable resin composition of the disclosure contains a flame retardant, the content thereof is not particularly limited as long as it is an amount sufficient to obtain a desired flame retardant effect. The content of the flame retardant is preferably 1 part by mass to 300 parts by mass, and more preferably 2 parts by mass to 150 parts by mass, relative to 100 parts by mass of the epoxy resin contained in the curable resin composition.

### (Ion exchanger)

The curable resin composition of the disclosure may contain an ion exchanger. In the case where the curable resin composition is used as a sealing material for a semiconductor package, it is preferable to contain an inorganic ion exchanger from the viewpoint of improving the moisture resistance and high-temperature storage characteristics of an electronic component device including an element to be sealed.
The ion exchanger is not particularly limited, and conventionally known ones may be used. Specific examples include hydrotalcite compounds and hydrous oxides of at least one element selected from the group consisting of magnesium, aluminum, titanium, zirconium, and bismuth. The ion exchanger may be used alone as one type, or two or more types may be used in combination. Specifically, examples of the ion exchanger include hydrotalcite represented by the following general formula (A).

Mg_{(1-X)}Al_{X}(OH)₂(CO₃)_{X/2}·mH₂O··· (A)

(0<X≦0.5, m is a positive number)

In the case where the curable resin composition of the disclosure contains an ion exchanger, the content thereof is not particularly limited as long as it is an amount sufficient to capture ions such as halogen ions. The content of the ion exchanger is preferably 0.1 part by mass to 30 parts by mass, and more preferably 1 part by mass to 6 parts by mass, relative to 100 parts by mass of the epoxy resin contained in the curable resin composition.

### (Physical Properties of the Curable Resin Composition)

From the viewpoint of fluidity, the curable resin composition of the disclosure preferably has a spiral flow determined by the following method of 90 cm or more, more preferably 120 cm or more, and further preferably 140 cm or more. The upper limit of the spiral flow is not particularly limited, and may be, for example, 170 cm or less.

The spiral flow is measured by determining the flow distance obtained by molding the curable resin composition using a spiral flow measurement mold conforming to EMMI-1-66 under conditions of a mold temperature of 175°C, a molding pressure of 6.9 MPa, and a curing time of 90 seconds.

From the viewpoint of fluidity and curability, the gel time of the curable resin composition at 175°C is preferably 15 seconds or more, more preferably 18 seconds or more, and further preferably 21 seconds or more.

The gel time is measured by placing 0.5 g of the thermosetting resin composition on a hot plate preheated to 175°C and measuring the time from when the thermosetting resin composition is placed thereon to when the viscosity of the resin is lost. It is preferable to heat the resin while periodically stirring it with a spatula or the like. "When the viscosity of the resin is lost" refers to a phenomenon in which the resin fractures or breaks apart when kneaded with a spatula or the like.

The linear expansion coefficient (α1) of the cured product of the curable resin composition at 10°C to 30°C may be 8.0 ppm/°C or more, and may be 9.0 ppm/°C to 12.0 ppm/°C.

From the viewpoint of preventing warpage of the package of the cured product of the curable resin composition of the disclosure, the linear expansion coefficient of the cured product of the curable resin composition at 180°C to 200°C is preferably 32.0 ppm/°C or more, more preferably 33.0 ppm/°C or more, and further preferably 34.0 ppm/°C or more. Previously, it had been considered that a lower linear expansion coefficient reduces delamination from the lead frame; however, in the curable resin composition of the disclosure, it has been found that a linear expansion coefficient of the cured product at 180°C to 200°C of 32.0 ppm/°C or more is more effective in preventing delamination from the lead frame. The reason for this is not clear, but it is inferred to be a thermal stress reduction effect due to the prevention of warpage caused by the difference in linear expansion coefficients between members. In particular, the curable resin composition of the disclosure enables a lower glass transition temperature (Tg), which may broaden the allowable range of the linear expansion coefficient.
From the viewpoint of preventing thermal stress generation with package members, the upper limit of the linear expansion coefficient is preferably 60 ppm/°C or less, more preferably 55 ppm/°C or less, and further preferably 50 ppm/°C or less.

In the disclosure, the linear expansion coefficient α1 and the linear expansion coefficient α2 are the slopes of the tangent line at 10°C to 30°C and the slopes of the tangent line at 180°C to 200°C, respectively, obtained by plotting the strain of the cured product against temperature using thermal mechanical analysis (TMA: Thermal Mechanical Analysis) based on JIS K 7197:2012. The measurement is performed with a test load of 98 mN and a heating rate of 5°C/min. The linear expansion coefficient may be measured using a thermomechanical analyzer (for example, TMA/SS6100 manufactured by Seiko Instruments Inc.).
The cured product is prepared by molding the curable resin composition using a transfer molding machine under conditions of a mold temperature of 175°C, a molding pressure of 6.9 MPa, and a curing time of 90 seconds, followed by post-curing at 175°C for 5 hours. The cured product has a rectangular shape with a short side of 5.1 mm, a long side of 20 mm, and a thickness of 2 mm.

From the viewpoint of heat resistance and the like, the glass transition temperature (Tg) of the cured product of the curable resin composition is preferably greater than 110°C, more preferably 112°C or more, and further preferably 115°C or more. The upper limit of the Tg is not particularly limited, and may be 200°C or less, or may be 180°C or less.

In the disclosure, the glass transition temperature of the cured product is defined as the temperature at the intersection of the tangent line at 10°C to 30°C and the tangent line at 200°C to 220°C, obtained from the measurement of the linear expansion coefficient described above.

From the viewpoint of the adhesiveness of the cured product of the curable resin composition to the lead frame, the elastic modulus of the cured product of the curable resin composition at 260°C is preferably 1000 MPa or less, more preferably 900 MPa or less, and further preferably 800 MPa or less, although this depends on the amount of filler.

The elastic modulus of the cured product of the curable resin composition is determined at 260°C by heating from 20°C to 300°C at 5°C/min using a viscoelastic measurement device (for example, RSAIII manufactured by TA Instruments) under conditions of a span distance of 40 mm and a frequency of 1 Hz by a three-point bending method. The cured product is prepared by the method described for the linear expansion coefficient. A cured product having a rectangular shape with a short side of 5.1 mm, a long side of 20 mm, and a thickness of 2 mm is used.

From the viewpoint of the adhesiveness of the cured product of the curable resin composition of the disclosure to the lead frame, the adhesive strength of the cured product to AgCu at room temperature (for example, 25°C) (also called adhesive strength 1) is preferably 7.0 MPa or more, and more preferably 7.5 MPa or more. The upper limit of the adhesive strength 1 is not particularly limited, and may be, for example, 10 MPa or less.

From the viewpoint of the adhesiveness of the cured product of the curable resin composition of the disclosure to the lead frame, the adhesive strength of the cured product to AgCu at 260°C after heating and humidifying at 85°C and 85% RH for 168 hours (also called adhesive strength 2) is 0.40 MPa or more, preferably 0.42 MPa or more, and more preferably 0.45 MPa or more. The upper limit of the adhesive strength 2 is not particularly limited, and may be, for example, 1.00 MPa or less.

For the measurement of the adhesive strength 1, first, the curable resin composition is molded on an Ag-plated Cu substrate by transfer molding and cured under conditions of 175°C and a curing time of 120 seconds, followed by post-curing under conditions of 175°C for 5 hours to prepare a sample. The cured product of the sample has a shape with a short side of 3.0 mm, a long side of 3.5 mm, and a thickness of 2.9 mm. The sample is measured by performing a shear strength test in which a tool of a bond tester device (for example, 4000 Optima manufactured by Nordson) is applied to the cured product under conditions of room temperature (for example, 25°C).

For the measurement of the adhesive strength 2, a sample is prepared in the same manner as for the measurement of the adhesive strength 1. The sample is heated and humidified at 85°C and 85% RH for 168 hours, and then measured by performing a shear strength test in which a tool of a bond tester device (for example, 4000 Optima manufactured by Nordson) is applied to the cured product under conditions of 260°C.

Regarding the curable resin composition of the disclosure, the curing shrinkage rate (shrinkage rate 1 in Examples) of a molded article molded under conditions of a mold temperature of 175°C, a molding pressure of 6.9 MPa, and a curing time of 90 seconds may be 0.37% or more, may be 0.38% or more, or may be 0.40% or more.
The upper limit of the curing shrinkage rate of the molded article described above is not particularly limited, and may be, for example, 0.50% or less.

### (Method for Producing Curable Resin Composition)

The method for producing the curable resin composition is not particularly limited. As a general method, a method may be listed in which components in predetermined blending amounts are sufficiently mixed by a mixer or the like, then melt-kneaded by a mixing roll, an extruder, or the like, cooled, and pulverized. More specifically, for example, a method may be listed in which predetermined amounts of the components described above are uniformly stirred and mixed, kneaded by a kneader, a roll, an extruder, or the like that has been heated in advance to 70°C to 140°C, cooled, and pulverized.

The curable resin composition is preferably a solid at 25°C. In the case where the curable resin composition is a solid at 25°C, the shape of the curable resin composition is not particularly limited, and examples include powder, granule, and tablet forms. From the viewpoint of handleability, the dimensions and mass of the curable resin composition in tablet form are preferably set to dimensions and mass that conform to the molding conditions of the package.

### (Applications of Curable Resin Composition)

The applications of the curable resin composition of the disclosure are not particularly limited, and the curable resin composition may be used, for example, as a sealing material for electronic component devices in various mounting technologies. Further, the curable resin composition of the disclosure may be used in various applications where it is desirable for the resin composition to have good fluidity and curability, such as resin molded articles for various modules, resin molded articles for motors, resin molded articles for in-vehicle use, and sealing material for protective materials for electronic circuits.

### <Electronic component device>

The electronic component device of the disclosure includes an element and a cured product of the curable resin composition that seals the element.

The electronic component device may include a support member on which the element is mounted.
Examples of the support member include a lead frame, a wired tape carrier, a wiring board, glass, a silicon wafer, and an organic substrate. Among the support members, a lead frame is preferable from the viewpoint of adhesiveness with the cured product of the curable resin composition.

The lead frame may or may not have a roughened surface; however, from the viewpoint of manufacturing cost, a lead frame is preferable, and from the viewpoint of adhesiveness, a roughened lead frame is preferable.
The roughening method is not particularly limited, and examples thereof include alkali treatment, silane coupling treatment, sand mat treatment, plasma treatment, and corona discharge treatment.

The lead frame preferably contains Ag, and may further contain Cu and the like.

Examples of the element included in the electronic component device include active elements such as silicon chips, transistors, diodes, and thyristors, and passive elements such as capacitors, resistors, and coils.

Specific configurations of the electronic component device include the following configurations, but are not limited thereto.
(1) A general resin-sealed IC having a structure in which an element is fixed on a lead frame, terminal parts of the element such as bonding pads and lead parts are connected using wire bonding, bumps, or the like, and then sealed using a curable resin composition, such as DIP (Dual Inline Package), PLCC (Plastic Leaded Chip Carrier), QFP (Quad Flat Package), SOP (Small Outline Package), SOJ (Small Outline J-lead Package), TSOP (Thin Small Outline Package), and TQFP (Thin Quad Flat Package);
(2) A TCP (Tape Carrier Package) having a structure in which an element connected to a tape carrier using bumps is sealed using a curable resin composition;
(3) A COB (Chip On Board) module, hybrid IC, multichip module, or the like having a structure in which an element connected to wiring formed on a support member using wire bonding, flip-chip bonding, solder, or the like is sealed using a curable resin composition;
(4) A BGA (Ball Grid Array), CSP (Chip Size Package), MCP (Multi Chip Package), SiP (System in a Package), or the like having a structure in which an element is mounted on a surface of a support member having terminals for wiring board connection formed on a back surface thereof, the element and wiring formed on the support member are connected using bumps or wire bonding, and then the element is sealed using a curable resin composition.

The method for sealing the element using the curable resin composition is not particularly limited, and a known method may be applied. As the sealing method, for example, low-pressure transfer molding is generally used, but injection molding, compression molding, casting, or the like may also be used.

### Examples

The disclosure is described below in detail by way of examples, but the disclosure is not limited to these examples. Further, the numerical values in the tables indicate "parts by mass" unless otherwise specified.

### [Examples 1 to 3 and Comparative Examples 1 to 2]

The materials having the formulation shown in Table 1 were pre-mixed (dry blended), then kneaded on a two-roll mill (roll surface temperature: approximately 80°C) for approximately 15 minutes, cooled, and pulverized to produce a powdered curable resin composition. The equivalent ratio of the phenolic hydroxyl groups (active hydrogen) of the phenolic curing agent to the epoxy groups of the epoxy resin was set to 0.7.

The details of the materials in Table 1 are as follows.
· Epoxy resin 1: triphenylmethane type epoxy resin represented by formula (2), epoxy equivalent weight 214 g/eq
· Epoxy resin 2: sulfur atom-containing type epoxy resin, epoxy equivalent weight 238 g/eq to 254 g/eq, melting point 116°C to 126°C
· Epoxy resin 3: biphenyl epoxy resin, epoxy equivalent weight 241 g/eq
· Epoxy resin 4: methoxynaphthylene-cresol formaldehyde co-condensation type epoxy resin, epoxy equivalent weight 250 g/eq
· Epoxy resin 5: biphenyl type epoxy resin, epoxy equivalent 192 g/eq
· Epoxy resin 6: biphenyl type epoxy resin, epoxy equivalent 192 g/eq
· Epoxy resin 7: biphenyl type epoxy resin, epoxy equivalent 192 g/eq
· Curing agent 1: aralkyl phenol resin, hydroxyl group equivalent weight 175 g/eq
· Curing agent 2: triphenylmethane type phenolic resin, hydroxyl group equivalent weight 104 g/eq
· Curing agent 3: alkyl-modified phenolic resin, hydroxyl group equivalent weight 224 g/eq
· Curing agent 4: biphenyl aralkyl type phenolic resin, hydroxyl group equivalent weight 204 g/eq
· Curing agent 5: aminotriazine-modified phenolic resin, amine equivalent weight 120 g/eq
· Ultraviolet absorber 1: benzotriazole-based ultraviolet absorber
· Ultraviolet absorber 2: triazine-based ultraviolet absorber
· Curing accelerator 1: adduct of triphenylphosphine with 1,4-benzoquinone
· Curing accelerator 2: triphenylphosphine
· Coupling agent 1: N-phenyl-3-aminopropyltrimethoxysilane
· Coupling agent 2: 3-glycidoxypropyltrimethoxysilane
· Coupling agent 3: bis(3-(triethoxysilyl)propyl)tetrasulfide
· Coupling agent 4: 3-mercaptopropyltrimethoxysilane
· Coupling agent 5: methyltrimethoxysilane
· Mold release agent: ester-based wax such as montanic acid ester
· Colorant: carbon black
· Ion exchanger 1: uncalcined hydrotalcite compound (Mg/Al=3.0)
· Ion exchanger 2: uncalcined hydrotalcite compound (Mg/Al=2.25)
· Ion exchanger 3: uncalcined hydrotalcite compound (Mg/Al=3.0)
· Stress relaxation agent 1: silicone-based stress relaxation agent having epoxy groups
· Stress relaxation agent 2: triphenylphosphine oxide
· Stress relaxation agent 3: coumarone resin, softening point 100°C, Nitto Chemical Co., Ltd.
· Stress relaxation agent 4: indene polymer
· Inorganic filler 1: spherical silica particles having a volume average particle diameter of 26.9 µm
· Inorganic filler 2: spherical silica particles having a volume average particle diameter of 0.5 µm
· Inorganic filler 3: spherical silica particles having a volume average particle diameter of 20 µm

### <<Evaluation of Curable Resin Composition>>

The properties of the curable resin compositions prepared in the Examples and Comparative Examples were measured and evaluated by the following methods. The evaluation results are shown in Table 2.

### <Measurement of Spiral Flow>

The spiral flow of the curable resin composition was measured by the method described above.

### <Measurement of Gel Time>

The gel time of the curable resin composition was measured by the method described above.

### <Measurement of Linear Expansion Coefficient>

The thermal expansion coefficient (α1) at 10°C to 30°C and the thermal expansion coefficient (α2) at 180°C to 200°C of the cured product of the curable resin composition were measured by the method described above. TMA/SS6100 manufactured by Seiko Instruments Inc. was used as the thermomechanical analyzer.

### <Measurement of Glass Transition Temperature (Tg) of Cured Product>

The temperature at the intersection of the tangent line at 10°C to 30°C and the tangent line at 200°C to 220°C, obtained from the measurement of the linear expansion coefficient described above, was taken as the glass transition temperature of the cured product.

### <Measurement of Shrinkage Rate 1>

Using a mold with pre-measured dimensions, disk-shaped molded articles (test pieces) of the curable resin compositions obtained in the Examples and Comparative Examples described above were molded by transfer molding under conditions of a mold temperature of 175°C, a molding pressure of 6.9 MPa, and a curing time of 90 seconds, and the test pieces were then allowed to cool to 25°C.
After cooling, the average value of the diameters at two points each on the front and back surfaces of the test piece was taken as Rm (mm), and the average value of the inner diameters at two points on the mold corresponding to the front surface of the test piece and the inner diameters at two points on the mold corresponding to the back surface of the test piece was taken as Rd (mm), and by substituting into the following formula, the curing shrinkage rate (shrinkage rate 1) of the curable resin composition was determined. $Shrinkage rate 1 \left(%\right) = \left[\left(Rd-Rm\right)/Rd\right] \times 100$

### <Measurement of Shrinkage Rate 2>

Using a mold with pre-measured dimensions, disk-shaped cured products (test pieces) of the curable resin compositions obtained in the Examples and Comparative Examples described above were molded by transfer molding under conditions of a mold temperature of 175°C, a molding pressure of 6.9 MPa, and a curing time of 90 seconds, and the test pieces were then allowed to cool to 25°C.
After cooling to 25°C, the test pieces were heated in an oven heated to 175°C for 5 hours, and the test pieces were then allowed to cool to 25°C.
After cooling, the average value of the diameters at two points each on the front and back surfaces of the test piece was taken as Rm (mm), and the average value of the inner diameters at two points on the mold corresponding to the front surface of the test piece and the inner diameters at two points on the mold corresponding to the back surface of the test piece was taken as Rd (mm), and by substituting into the following formula, the curing shrinkage rate (shrinkage rate 2) of the curable resin composition was determined. $Shrinkage rate 2 \left(%\right) = \left[\left(Rd-Rm\right)/Rd\right] \times 100$

### <Measurement of Adhesive Strength 1 to AgCu>

By the method described above, the adhesive strength 1 to AgCu of the cured product of the curable resin composition was measured. As a measurement device, a product named 4000 Optima manufactured by Nordson Corporation was used.

### <Measurement of Adhesive Strength 2 to AgCu>

By the method described above, the adhesive strength 2 to AgCu of the cured product of the curable resin composition was measured. As a measurement device, a product named 4000 Optima manufactured by Nordson Corporation was used.

### <Evaluation of Peeling Properties Under High-Temperature Moisture Absorption Conditions>

An 80-pin flat package (lead frame material: AgCu) having external dimensions of 20 mm in length, 14 mm in width, and 2 mm in thickness, on which a silicon chip (8 mm in length, 10 mm in width, and 0.4 mm in thickness) sealed using the cured product of the curable resin composition formed under the above conditions was mounted, was fabricated.
The above package was heated under conditions of 85°C, 85% RH for 168 hours (MSL1).
Thereafter, a reflow treatment was performed at 260°C for 10 seconds, and the presence or absence of delamination occurring inside the package was observed using an ultrasonic flaw detector (manufactured by Hitachi Construction Machinery Co., Ltd., HYE-FOCUS). The peeling properties were evaluated based on the ratio of the number of packages in which delamination occurred (Fail) to the number of test packages (Total: 16).

**[Table 1]**

| | Example 1 | Example 2 | Example 3 | Comparative Example 1 | Comparative Example 2 |
|---|---|---|---|---|---|
| Epoxy resin 1 | 35 | 80 | 40 | | |
| Epoxy resin 2 | 45 | | 40 | | |
| Epoxy resin 3 | | | | | 53 |
| Epoxy resin 4 | | | | 69 | |
| Epoxy resin 5 | 23 | 23 | 23 | 15 | |
| Epoxy resin 6 | | | | 19.8 | |
| Epoxy resin 7 | | | | | 27.6 |
| Curing agent 1 | 25.7 | | 55.6 | 62.6 | 57.5 |
| Curing agent 2 | 15.1 | 32 | | | |
| Curing agent 3 | 5 | 5 | | 8 | |
| Curing agent 4 | | | | | 19.5 |
| Curing agent 5 | | | | 3 | 3 |
| Ultraviolet absorber 1 | | | | 5 | |
| Ultraviolet absorber 2 | | | | 5 | |
| Curing accelerator 1 | 3.2 | 3.2 | 3.2 | 5 | 1.6 |
| Curing accelerator 2 | | | | | 7.8 |
| Coupling agent 1 | 3 | 3 | 3 | 3 | 4.5 |
| Coupling agent 2 | 3 | 3 | 3 | 4.5 | |
| Coupling agent 3 | | 2 | 2 | | |
| Coupling agent 4 | 5 | | 3 | 0.15 | 0.15 |
| Coupling agent 5 | | | | | 3 |
| Mold release agent | 1 | 1 | 1 | 1 | 1 |
| Colorant | 3 | 3 | 3 | 4 | 2.8 |
| Ion exchanger 1 | 3 | 3 | 3 | | |
| Ion exchanger 2 | | | | 3 | |
| Ion exchanger 3 | | | | | 10 |
| Stress relaxation agent 1 | 20 | 20 | 20 | | |
| Stress relaxation agent 2 | 10 | 10 | 10 | 10 | 5 |
| Stress relaxation agent 3 | 20 | 20 | 20 | 10 | 1.5 |
| Stress relaxation agent 4 | | | | | 1.5 |
| Inorganic filler 1 | 1247 | 1355 | 1736 | 1723 | |
| Inorganic filler 2 | | | | | 164 |
| Inorganic filler 3 | | | | | 1479 |
| Content rate of the inorganic filler (% by volume) | 75 | 77.5 | 80 | 80 | 80 |
| Total | 1467 | 1563.2 | 1965.8 | 1951.05 | 1842.45 |

**[Table 2]**

| | Example 1 | Example 2 | Example 3 | Comparative Example 1 | Comparative Example 2 |
|---|---|---|---|---|---|
| Spiral flow (cm) | 152 | 122 | 97 | 86 | 94 |
| Gel time (second) | 31 | 36 | 30 | 25 | 36 |
| Glass transition temperature (°C) | 114 | 122 | 112 | 104 | 110 |
| α1 (ppm/°C) | 10.7 | 9.6 | 9.2 | 8.7 | 8.2 |
| α2 (ppm/°C) | 44.2 | 35.0 | 34.0 | 31.5 | 31.9 |
| Shrinkage rate 1 (%) | 0.41 | 0.40 | 0.38 | 0.36 | 0.36 |
| Shrinkage rate 2 (%) | 0.43 | 0.26 | 0.30 | 0.30 | 0.32 |
| Adhesive strength 1 (MPa) | 8.7 | 7.6 | 7.6 | 6.1 | 6.9 |
| Adhesive strength 2 (MPa) | 0.47 | 0.53 | 0.50 | 0.24 | 0.23 |
| MSL 1(Fail/total) | 0/16 | 0/16 | 0/16 | 16/16 | 16/16 |

As shown in Table 2, under heating and humidification conditions of 85°C, 85% RH for 168 hours, it can be seen that delamination is significantly reduced in the Examples compared to the Comparative Examples.

The disclosure of Japanese Patent Application No. 2023-219887, filed on December 26, 2023, is incorporated herein by reference in its entirety.
All documents, patent applications, and technical standards mentioned in this specification are incorporated herein by reference to the same extent as if each individual document, patent application, and technical standard was specifically and individually indicated to be incorporated by reference.

## Claims

1. A curable resin composition, comprising an epoxy resin,
wherein an adhesive strength of a cured product to AgCu at 260°C after heating and humidifying at 85°C and 85% RH for 168 hours is 0.40 MPa or more.

2. The curable resin composition according to claim 1, further comprising a curing agent,
wherein an equivalent ratio of the curing agent to the epoxy resin, which is curing agent/epoxy resin, is 0.8 or less.

3. The curable resin composition according to claim 1, wherein a cured product has a glass transition temperature greater than 110°C.

4. The curable resin composition according to claim 1, wherein a thermal expansion coefficient α2 measured at 180°C to 200°C is 32.0 ppm/°C or more.

5. The curable resin composition according to claim 1, wherein the epoxy resin comprises at least one selected from a group consisting of a triphenylmethane type epoxy resin containing a t-Bu group and a biphenyl epoxy resin.

6. The curable resin composition according to claim 1, further comprising an inorganic filler.

7. An electronic component device, comprising:
an element; and
a cured product of the curable resin composition according to any one of claims 1 to 6, sealing the element.

8. The electronic component device according to claim 7, further comprising a lead frame having the element mounted on one surface of the lead frame.

9. The electronic component device according to claim 8, wherein the lead frame contains Ag.
